# FASCICULE DE BREVET EUROPEEN

(11) **EP 1 742 313 B1**
(45) Date de publication et mention de la délivrance du brevet: **15.10.2008**
(21) Numéro de dépôt: 06116862.1
(22) Date de dépôt: 07.07.2006
(51) Int. Cl.: H01S 5/026, H01S 5/042, G02F 1/095

(54) **Dispositif optique à source laser à semi-conducteur et isolateur optique intégrés**
Optische Vorrichtung mit integrierten Halbleiter-Laser und optischem Isolator
Optical device with integrated semiconductor laser and optical isolator

(30) Priorité: 08.07.2005 FR 0507320
(43) Date de publication de la demande: 10.01.2007
(73) Titulaire: Alcatel Lucent, 75008 Paris (FR)
(72) Inventeur: Accard, Alain, 91460, MARCOUSSIS (FR); Dagens, Béatrice, 92160, ANTONY (FR)
(74) Mandataire: Shamsaei Far, Hassan

(56) Documents cités:
- EP-A- 0 397 089
- EP-A- 1 039 330
- US-A1- 2004 179 256
- TAKENAKA M ET AL: "PROPOSAL OF A NOVEL SEMICONDUCTOR OPTICAL WAVEGUIDE ISOLATOR" INTERNATIONAL CONFERENCE ON INDIUM PHOSPHIDE AND RELATED MATERIALS, 16 mai 1999 (1999-05-16), pages 289-292, XP000974917
- SAKURAI K ET AL: "Monolithic integration of laser diode and magneto-optic waveguide" LASERS AND ELECTRO-OPTICS EUROPE, 2003. CLEO/EUROPE. 2003 CONFERENCE ON MUNICH, GERMANY 22-27 JUNE 2003, PISCATAWAY, NJ, USA,IEEE, 22 juin 2003 (2003-06-22), pages 602-602, XP010712123 ISBN: 0-7803-7734-6

## Description

Le domaine de l'invention est celui des dispositifs optiques comportant une source d'émission laser semi-conducteur et un isolateur optique intégrés. Ces dispositifs sont utilisés principalement dans le domaine des télécommunications numériques haut débit.

On sait qu'une source laser peut être rendue instable par un faisceau optique parasite issu du faisceau d'émission initial et réfléchi par une surface optique externe à la cavité du laser. Dans la suite du texte, on appellera indifféremment source laser ou laser une source d'émission de lumière comportant un amplificateur optique de type laser. Pour diminuer ce phénomène, on dispose à la sortie du laser un isolateur optique. Sa fonction est de laisser passer la lumière issue du laser et d'éliminer toute lumière parasite venant dans le sens opposé.

Par principe, un isolateur optique met en oeuvre un effet optique non réciproque permettant d'assurer cette fonction. Le plus connu est l'effet Faraday. Soumis à un champ magnétique externe, certains matériaux dits magnéto-optiques font tourner le plan de polarisation de la lumière dans un sens différent selon le sens de propagation de la lumière. Ainsi, en plaçant ce type de matériau entre polariseurs convenablement disposés, il est possible de transmettre la lumière se propageant dans un premier sens et de la bloquer dans le sens opposé. Ces dispositifs sont mal adaptés aux dispositifs optiques comportant des lasers à semi-conducteurs dans la mesure où ils nécessitent un certain nombre de composants difficilement intégrables dans des dispositifs dont les dimensions sont de l'ordre du millimètre.

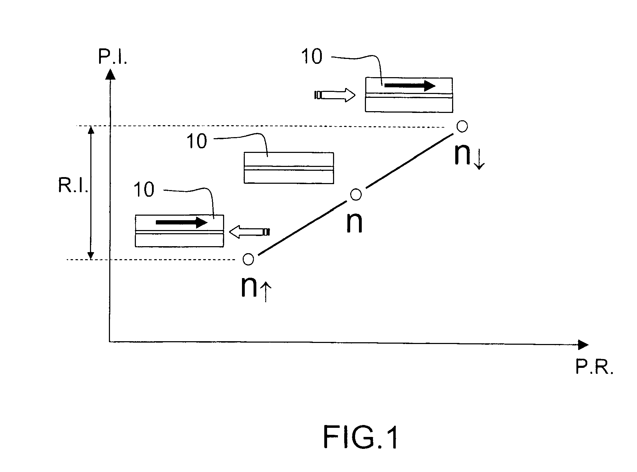

Enfin, il est possible d'utiliser des isolateurs optiques à absorption non réciproque. On sait que l'indice optique est complexe. Il comprend une partie réelle et une partie imaginaire proportionnelle à l'absorption du matériau. Or, en présence de champ magnétique, l'indice optique de certains matériaux de type ferromagnétique dépend du sens de propagation de la lumière. La figure 1 présente les variations des parties réelle et imaginaire de l'indice optique du mode optique dit transverse magnétique TM de ce type de matériau en fonction du sens de propagation de la lumière. En l'absence de champ magnétique, l'indice optique dans le matériau 10 vaut n. En présence d'un champ magnétique symbolisé par une flèche noire, selon le sens de propagation de la lumière symbolisée par une flèche droite rayée, l'indice n devient n↑ dans un premier sens de propagation et n↓ dans le sens opposé. La différence entre les deux parties imaginaires P.I. des indices n↑ et n↓ donne le ratio d'isolation R.I.. Par conséquent, selon son sens de propagation, un faisceau de lumière sera plus ou moins absorbé par ce type de matériau.

Ces derniers isolateurs sont bien adaptés pour être intégrés à des dispositifs optiques comportant une source laser semi-conducteur. Dans ce cas, ils sont généralement intégrés à une structure amplificatrice de type SOA, acronyme anglo-saxon signifiant Semiconductor Optical Amplifier. Ainsi, l'amplification optique fournie par le SOA compense, dans un premier sens de propagation, l'absorption plus faible du matériau. Dans le sens opposé de propagation, l'absorption reste prédominante et atténue le faisceau de lumière de façon à éviter les retours.

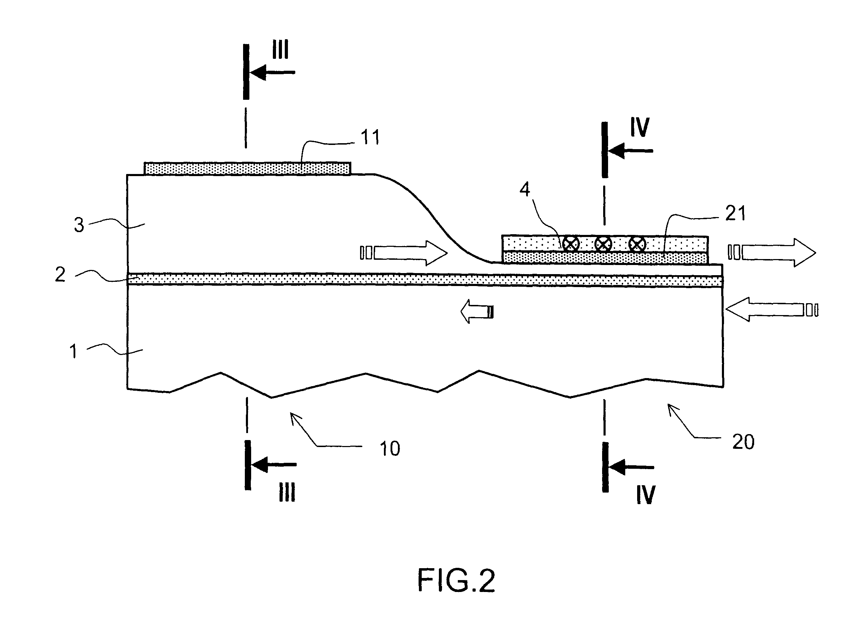

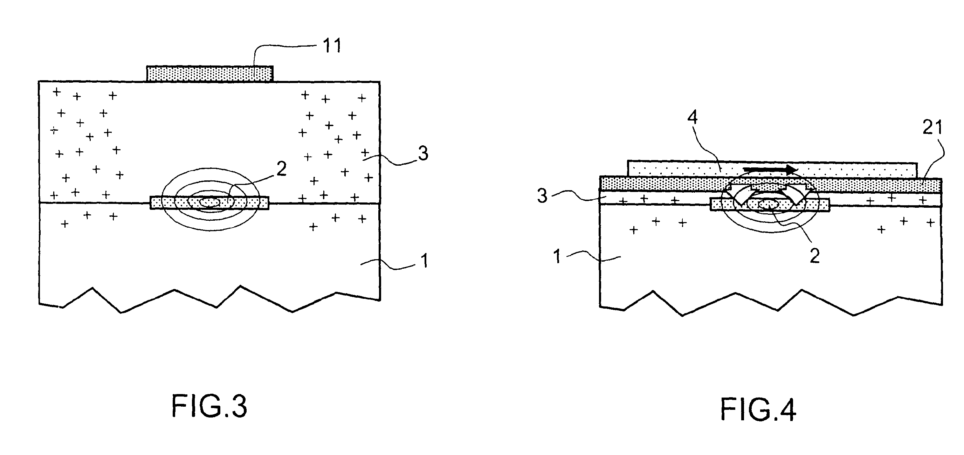

Les figures 2, 3 et 4 représentent un dispositif de ce type. La figure 2 est une vue en coupe longitudinale et les figures 3 et 4 représentent des vues en coupe transversale. La structure comporte essentiellement deux parties qui sont d'une part un laser à semi-conducteur 10 et d'autre part un isolateur optique à absorption 20, l'ensemble reposant sur un substrat commun 1.

Le laser semi-conducteur 10 est une structure dite à ruban enterré encore appelée structure BRS, acronyme anglo-saxon de Buried Ridge Stripe. Le schéma en coupe d'une telle structure est représenté sur la figure 3. Elle comprend essentiellement :
- Le substrat commun 1 en matériau semi-conducteur dopé n. Ce premier substrat est généralement en InP ;
- Une partie active 2 formée par un ruban de section droite rectangulaire, la face inférieure de cette partie active reposant sur le premier substrat 1. La partie active a un indice optique supérieur à celui des couches qui l'entourent. Elle est de faible section, de l'ordre du micromètre ou de quelques microns, et est généralement en GaInAsP ou en GaInAIAs ou en GaInNAs ;
- Une couche 3 en matériau semi-conducteur dopé p. Cette couche est également en InP et elle recouvre complètement les faces latérales et la face supérieure de la partie active 2. Son épaisseur est de quelques micromètres, typiquement 2 à 3 ;
- Une couche de contact électrique disposée sous le premier substrat 1 non représentée sur les figures et une couche de contact électrique supérieure 11 disposée sur le second substrat 3. Ces couches sont généralement en InP/InGaAs. Les électrodes sont disposées sur ces couches de contact. Elles amènent le courant nécessaire au fonctionnement du laser. Généralement, les électrodes sont en alliage d'or et de platine.
- Une implantation de protons est généralement réalisée dans la couche dopée p, de part et d'autre de la zone active, pour améliorer le confinement électrique. Cette implantation est représentée par des symboles + sur les différentes figures.

Cette configuration permet d'assurer, à la fois :
- Un confinement des porteurs injectés dans le ruban si la différence de largeur de bande interdite entre le matériau du premier substrat et celui du second substrat est suffisante ;
- Un guidage bidirectionnel de la lumière si la différence d'indice optique entre le matériau du premier substrat et celui du second substrat est également suffisante.

Ces lasers émettent généralement dans le proche infra-rouge à des longueurs d'onde voisines de 1,3 micromètre ou de 1,5 micromètre. Il est possible d'adjoindre des couches supplémentaires pour réaliser d'autres fonctions. En particulier, en ajoutant sur la couche active un réseau optique, il est possible de réaliser un laser à « contre-réaction répartie » dit DFB, acronyme anglo-saxon de « Distributed Feed Back ».

L'isolateur optique 20 est également une structure dite à ruban enterré. Le schéma en coupe d'une telle structure est représenté sur la figure 4. Elle comprend essentiellement et successivement :
- Le substrat 1 en matériau semi-conducteur en InP dopé n commun avec celui du laser ;
- Une partie active 2 également commune avec celle du laser ;
- Une couche 3 en matériau semi-conducteur dopé p. Cette couche également commune avec celle du laser est cependant, dans la partie isolateur, d'épaisseur beaucoup plus faible de façon que le champ magnétique soit au plus près de la couche active. Son épaisseur ne dépasse pas quelques dixièmes de micromètres.
- Une couche de contact électrique disposée sous le premier substrat 1 non représentée sur les figures et une couche de contact électrique supérieure 21 disposée sur le second substrat 3. Les électrodes sont disposées sur ces couches de contact. Les électrodes amènent le courant nécessaire à l'amplification du rayonnement laser.
- Une couche de matériau ferromagnétique 4 qui peut être, par exemple, en alliage de Fer-Cobalt. La magnétisation du matériau est symbolisé par une flèche sur la figure 4 et par des cercles comportant une croix centrale sur la figure 2. Cette couche assure à la fois la magnétisation de la couche active et le contact électrique.

L'implantation de protons dans les couches 1 est symbolisé par le symbole +.

Le faisceau optique émis par le laser semi-conducteur se propage à travers la couche active commune au laser et à l'isolateur et la couche de contact électrique. Il est représenté par des flèches droites rayées sur la figure 2 et par une série d'ellipses concentriques en traits fins sur les figures 3 et 4.

Cette configuration permet d'assurer à la fois l'amplification du faisceau lumineux issu du laser à semi-conducteur et l'absorption de la lumière parasite venant en sens inverse du sens de propagation comme indiqué par les flèches droites rayées de la figure 2. Les longueurs des flèches sont représentatives des amplitudes des faisceaux optiques. Avec ce type de configuration, il est possible d'assurer un ratio d'isolation supérieur à 25 dB avec une longueur d'isolateur optique de l'ordre de 1 à 2 millimètres.

Cependant, ce type de configuration présente plusieurs inconvénients majeurs. La couche de contact électrique étant très proche de la zone active, elle perturbe la propagation du mode optique et provoque des pertes optiques importantes. La structure des contacts électriques n'étant pas optimisée, des pertes électriques importantes peuvent intervenir, provoquant des échauffements locaux. Enfin, la faible épaisseur du substrat 3 nécessaire au fonctionnement de l'isolateur pose des problèmes de réalisation technologiques, délicats à maîtriser.

Il est bien entendu possible pour résoudre ces difficultés de changer l'agencement de la structure. Dans ce cas, on perd la possibilité d'intégrer dans un seul et même composant à la fois le laser BRS et l'isolateur optique. D'autre part, ce type de structure a des performances plus réduites.

L'objet de l'invention est un isolateur optique qui, tout en conservant la structure BRS qui permet l'intégration d'un ensemble laser-isolateur ne présente pas les inconvénients précédents.

Plus précisément, l'invention a pour objet un dispositif opto-électronique comprenant au moins une structure amplificatrice de type SOA qui comporte un isolateur optique, ladite structure comportant au moins et successivement :
- un substrat en matériau semi-conducteur dopé n ;
- une zone active enterrée en forme de ruban comprenant une face inférieure au contact du substrat, une face supérieure et deux faces latérales ;
- une couche de confinement vertical dopé p ;
- une couche de contact électrique et ;
- une couche de matériau magnéto-optique ,
caractérisé en ce que au moins la partie supérieure de la structure, située au-dessus de la face supérieure de la zone active est dépourvue de couche de contact dans une zone centrale de dimensions au moins égales à celles de ladite zone active.

Il en résulte que l'injection du courant dans la zone active venant de la couche de contact se fait principalement par les faces latérales ou les bords latéraux de la face supérieure de la zone active.

Pour chaque cas particulier de structure, des valeurs optimales des dimensions de la zone centrale peuvent évidemment être déterminées par simulations et expérimentalement.

Avantageusement, la couche de contact comporte au moins deux parties principales entourant cette zone centrale dépourvue de couche de contact, située au-dessus de la face supérieure de la zone active, la largeur de ladite zone centrale étant égale à environ 1,5 fois la largeur de la zone active.

Avantageusement, une couche conductrice est disposée au-dessus de la couche de matériau magnéto-optique.

Avantageusement, le dispositif comporte en outre, une section comportant une source d'émission à laser semi-conducteur à ruban enterré de type BRS, ladite section comprenant au moins un substrat, une couche active et une couche de confinement vertical communs à ceux de la structure amplificatrice, de façon que l'isolateur optique assure l'isolation dudit laser. Le laser peut être de type à « contre-réaction répartie » dit DFB et comporte alors un réseau optique disposé sur ou à proximité de la couche active.

Avantageusement, le matériau du substrat et de la couche de confinement est de l'InP, la zone active comporte au moins une structure à multiple puits quantiques dite MQW, le matériau de la couche magnéto-optique est en Fe/Co, le matériau de la couche de contact est en Pt/InGaAs et le matériau de la couche conductrice est en or.

Avantageusement, l'épaisseur de la couche de confinement située au-dessus de la zone active dans la zone de l'isolateur optique vaut environ 0,3 micromètre.

L'invention concerne également un procédé de réalisation d'un dispositif opto-électronique comprenant au moins une structure amplificatrice de type SOA comportant un isolateur optique selon l'invention, caractérisé en ce que le procédé de réalisation comporte au moins les deux étapes suivantes qui sont :
- Etape 1 : réalisation de la couche de contact sur la partie de la structure correspondant à l'isolateur optique ;
- Etape 2 : suppression de la couche de contact dans la zone de la structure située au-dessus de la face supérieure de la zone active, cette étape du procédé est réalisé par gravure chimique ou par RIE, acronyme anglo-saxon signifiant Reactive lonic etching.

L'invention sera mieux comprise et d'autres avantages apparaîtront à la lecture de la description qui va suivre donnée à titre non limitatif et grâce aux figures annexées parmi lesquelles :
- La figure 1 représente les variations de l'indice optique d'un matériau magnéto-optique en fonction du sens de propagation de la lumière ;
- La figure 2 représente une vue en coupe longitudinale d'un dispositif opto-électronique comportant un isolateur selon l'art antérieur ;
- La figure 3 représente une première vue en coupe transversale d'un dispositif opto-électronique comportant un isolateur selon l'art antérieur ;
- La figure 4 représente une seconde vue en coupe transversale d'un dispositif opto-électronique comportant un isolateur selon l'art antérieur ;

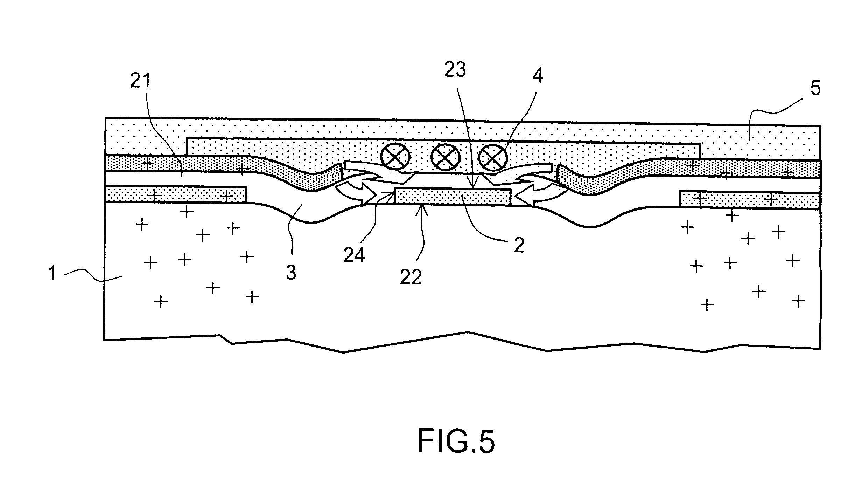

- La figure 5 représente une vue en coupe transversale d'un dispositif opto-électronique comportant un isolateur selon l'invention.

Comme on l'a vu, un des inconvénients majeurs des structures à isolateur optique selon l'art antérieur est que la couche de contact électrique est très proche de la zone active afin que le matériau magnéto-optique soit au plus près de ladite zone. Cette configuration est généralement adoptée parce qu'elle permet d'injecter facilement le courant dans la zone active comme indiqué par les flèches pleines verticales de la figure 4 représentant l'injection de courant.

Le coeur de l'invention est de découpler les moyens d'injection de courant permettant d'assurer l'amplification du SOA, des moyens magnéto-optiques permettant d'assurer l'effet non réciproque de l'isolateur. A cette fin, la couche de contact électrique est disposée de telle sorte que l'injection des porteurs de charges se fasse par les faces latérales et les bords de la face supérieure de la couche active. On assure ainsi à la fois l'amplification et l'isolation sans avoir les inconvénients des dispositifs selon l'art antérieur. Des essais effectués par le demandeur ont montré qu'une injection de courant obliquement par les faces latérales présente des performances similaires à celles d'une injection classique perpendiculairement à la face supérieure de la zone active.

A titre d'exemple non limitatif, la figure 5 représente une vue en coupe transversale partielle d'un dispositif opto-électronique comportant un isolateur à SOA selon l'invention. Ce dispositif est destiné à fonctionner dans le proche infra-rouge à des longueurs d'onde voisines de 1,3 micromètre ou de 1,5 micromètre.

Cet isolateur comprend successivement :
- un substrat 1 en matériau semi-conducteur dopé n qui peut être réalisé en InP,
- une zone active 2 enterrée en forme de ruban comprenant une face inférieure 22 au contact du substrat, une face supérieure 23 et deux faces latérales 24, la zone active peut comporter au moins une structure à multiple puits quantiques dite MQW, acronyme anglo-saxon de Multiple Quantum Wells, sa largeur est de l'ordre de 1 à 2 microns et son épaisseur de quelques dixièmes de micromètre.
- une couche 3 de confinement vertical dopé p. Cette couche couvre toute la zone active. Son épaisseur au dessus de la zone active est réduite à quelques dixièmes de micromètre. Elle est également réalisée en InP.
- une couche de contact électrique 21. Comme indiqué sur la figure 5, cette couche s'interrompt au dessus de la surface supérieure de la zone active sur une largeur égale à environ 1,5 fois la largeur de la zone active. Cette couche de contact est, par exemple, réalisée en Pt/InGaAs. L'injection du courant dans la zone active venant de ladite couche de contact se faisant principalement par les faces latérales 24 et les bords de la face supérieure 23 de la zone active 2 comme indiqué par les flèches pleines courbées de la figure 5.
- une couche de matériau magnéto-optique 4 qui couvre, au moins, la couche de confinement vertical dans sa partie située au-dessus de la face supérieure de la zone active. Le matériau de la couche magnéto-optique peut être en alliage de Fe/Co. Les pourcentages de fer peuvent être compris entre 10 à 50 % et les pourcentages de cobalt entre 50 à 90 %. Cette couche est magnétisée comme indiqué par des cercles comportant une croix centrale.
- Une couche de matériau conducteur 5 faisant électrode. Cette couche est en contact avec la couche de contact électrique 21. Elle peut être en or.

Comme sur les figures précédentes, l'implantation de protons dans les couches est symbolisé par les symboles +.

Bien entendu, cette structure comporte généralement sur le même substrat 1 une section comportant une source d'émission à laser semi-conducteur à ruban enterré de type BRS comprenant au moins une couche active et une couche de confinement vertical dopé p communes à celles de la structure amplificatrice SOA, de façon que l'isolateur optique assure l'isolation dudit laser. La couche de confinement est plus épaisse dans la section laser et vaut typiquement de 2 à 3 micromètres. La source laser peut être de type à « contre-réaction répartie » dit DFB et comporte alors un réseau optique disposé sur la couche active.

Le procédé de réalisation d'un dispositif opto-électronique comprenant au moins une structure amplificatrice de type SOA comportant un isolateur optique selon l'invention ne pose pas de problèmes technologiques particuliers et peut être réalisé classiquement par des méthodes de croissance épitaxiale suivi d'opérations de gravure. Le dépôt du matériau magnéto-optique peut être réalisé par pulvérisation.

Le procédé de réalisation comporte au moins les deux étapes suivantes qui sont :
- Etape 1 : réalisation de la couche de contact sur la partie de la structure correspondant à l'isolateur optique ;
- Etape 2 : suppression de la couche de contact dans la zone de la structure située au-dessus de la face supérieure de la zone active, cette étape du procédé est réalisée classiquement par gravure chimique ou ionique.

## Revendications

1. Dispositif opto-électronique comprenant au moins une structure amplificatrice de type SOA qui comporte un isolateur optique (20), ladite structure comportant au moins et successivement :
• un substrat (1) en matériau semi-conducteur dopé n ;
• une zone active (2) enterrée en forme de ruban comprenant une face inférieure (22) au contact du substrat, une face supérieure (23) et deux faces latérales (24) ;
• une couche (3) de confinement vertical dopé p ;
• une couche de contact électrique (21) et ;
• une couche de matériau magnéto-optique (4),
**caractérisé en ce que** au moins la partie supérieure de la structure, située au-dessus de la face supérieure (23) de la zone active (2) est dépourvue de couche de contact dans une zone centrale de dimensions au moins égales à celles de ladite zone active (2).

2. Dispositif opto-électronique selon la revendication 1, **caractérisé en ce que** la couche de contact comporte au moins deux parties principales entourant ladite zone centrale dépourvue de couche de contact, située au-dessus de la face supérieure de la zone active (2), la largeur de ladite zone centrale étant égale à environ 1,5 fois la largeur de la zone active.

3. Dispositif opto-électronique selon la revendication 1, **caractérisé en ce qu'**une couche conductrice (5) est disposée au-dessus de la couche de matériau magnéto-optique (4).

4. Dispositif opto-électronique selon la revendication 1, **caractérisé en ce que** le dispositif comporte en outre, une section comportant une source d'émission à laser semi-conducteur (10) à ruban enterré de type BRS, ladite section comprenant au moins un substrat (1), une couche active (2) et une couche (3) de confinement vertical dopé p communs à ceux de la structure amplificatrice, de façon que l'isolateur optique assure l'isolation dudit laser.

5. Dispositif opto-électronique selon l'une des revendications précédentes, **caractérisé en ce que** la zone active comporte au moins une structure à multiple puits quantiques dite MQW.

6. Dispositif opto-électronique selon l'une des revendications précédentes, **caractérisé en ce que** l'épaisseur de la couche de confinement située au-dessus de la zone active dans la zone de l'isolateur optique vaut environ 0,3 micromètre.

7. Procédé de réalisation d'un dispositif opto-électronique comprenant au moins une structure amplificatrice de type SOA comportant un isolateur optique selon l'une des revendications précédentes, **caractérisé en ce que** le procédé de réalisation comporte au moins les deux étapes suivantes qui sont :
• Etape 1 : réalisation de la couche de contact sur la partie de la structure correspondant à l'isolateur optique ;
• Etape 2 : suppression de la couche de contact dans la zone de la structure située au-dessus de la face supérieure de la zone active.

8. Procédé de réalisation selon la revendication 7, **caractérisé en ce que** l'étape 2 du procédé est réalisée par gravure chimique ou ionique.

## Claims

1. An optoelectronic device comprising at least one SOA amplifier structure that includes an optical insulator (20), said structure including at least and in succession,
• a substrate (1) made of an n-doped semiconductive material;
• a buried ridge stripe active area (2) comprising an inner surface (22) in contact with the substrate, an upper surface (23) and two side surfaces (24);
• a p-doped vertical confinement layer (3);
• an electrical contact layer (21); and
• a layer of magneto-optical material (4),
**characterized in that** at least the upper part of the structure, located above the upper surface (23) of the active area (2) is free from the contact layer within a central area having dimensions which are at least equal to those in said active area (2).

2. An optoelectronic device according to claim 1, **characterized in that** the contact layer includes at least two main parts surrounding said central area free of the contact layer, located above the upper surface of the active area (2), the width of said central area being equal to approximately 1.5 times the width of the active area.

3. An optoelectronic device according to claim 1, **characterized in that** a conductive layer (5) is placed above the magneto-optical material layer (4).

4. An optoelectronic device according to claim 1, **characterized in that** the device further includes a section including a buried ridge stripe semiconductor laser emission source (10), staid section comprising at least one substrate (1), one active layer (2), and one p-doped vertical confinement layer (3), all shared by those of the amplifier structure, so that the optical insulator ensures the insulation of said laser.

5. An optoelectronic device according to one of the preceding claims, **characterized in that** the active area includes at least one multiple quantum well, or MQW, structure.

6. An optoelectronic device according to one of the preceding claims, **characterized in that** the thickness of the confinement layer located above the active area within the optical insulator area is approximately 0.3 micrometers.

7. A method for constructing an optoelectronic device comprising at least one SOA amplifier structure, including an optical insulator according to one of the preceding claims, **characterized in that** the construction method includes at least the two following steps, which are:
• Step 1: Constructing the contact layer on the part of the structure corresponding to the optical insulator;
• Step 2: Removing the contact layer within the structure located above the upper surface of the active area.

8. A construction method according to claim 7, **characterized in that** step 2 of the method is performed through chemical or ionic etching.

## Patentansprüche

1. Opto-elektronische Vorrichtung, welche mindestens eine Verstärkerstruktur vom Typ SOA umfasst, welche einen optischen Isolator (20) enthält, wobei die besagte Struktur mindestens und der Reihe nach enthält:
. Ein Substrat (1) aus einem n-dotierten halbleitenden Material;
. Eine erdverlegte aktive Zone (2), welche die Form eines Bandes aufweist und eine mit dem Substrat in Kontakt tretende Unterseite (22), eine Oberseite (23) und zwei seitliche Seitenflächen (24) umfasst;
. eine p-dotierte senkrechte Begrenzungsschicht (3);
. eine elektrische Kontaktschicht (21); und
. eine Schicht aus einem magneto-optischen Material (4),
**dadurch gekennzeichnet, dass** mindestens der obere Teil der Struktur, welcher sich über der Oberseite (23) der aktiven Zone (2) befindet, in der Mittenzone, deren Abmessungen mindestens den Abmessungen der besagten aktiven Zone (2) entsprechen, keine Kontaktschicht aufweist,

2. Opto-elektronische Vorrichtung nach Anspruch 1, **dadurch gekennzeichnet**, das die Kontaktschicht mindestens zwei Hauptabschnitte enthält, welche die besagte Mittenzone ohne Kontaktschicht, die sich über der Oberseite der besagten aktiven Zone (2) befindet, umgeben, wobei die Breite der besagten Mittenzone mindestens ca. 1,5 mal die Breite der aktiven Zone beträgt.

3. Opto-elektronische Vorrichtung nach Anspruch 1, **dadurch gekennzeichnet, dass** ober der Schicht aus einem magneto-optischen Material (4) eine leitende Schicht (5) angebracht ist.

4. Opto-elektronische Vorrichtung nach Anspruch 1, **dadurch gekennzeichnet, dass** die Vorrichtung weiterhin einen Abschnitt, welcher eine Halbleiter-Laserquelle (10) mit einem erdverlegten Band vom Typ BRS enthält, umfasst, wobei der besagte Abschnitt mindestens ein Substrat (1), eine aktive Schicht (2) und eine p-dotierte senkrechte Begrenzungsschicht (3), welche denen der Verstärkerstruktur gemein sind, umfasst, so dass der optische Isolator die Isolierung des besagten Lasers gewährleistet.

5. Opto-elektronische Vorrichtung nach einem beliebigen der vorstehenden Ansprüche, **dadurch gekennzeichnet, dass** die aktive Zone mindestens eine sogenannte MQW-Struktur mit multiplen Quantentöpfen umfasst.

6. Opto-elektronische Vorrichtung nach einem beliebigen der vorstehenden Ansprüche, **dadurch gekennzeichnet, dass** die Dicke der Begrenzungsschicht, welche sich über der aktiven Zone in der Zone des optischen Isolators befindet, ca. 0,3 Mikrometer betragt.

7. Herstellungsverfahren einer opto-elektronischen Vorrichtung, welche mindestens eine Verstärkerstruktur vom Typ SOA, die einen optischen Isolator gemäß einem der vorstehenden Ansprüche enthält, umfasst, **dadurch gekennzeichnet, dass** das Herstellungsverfahren mindestens die folgenden zwei Schnitte umfasst:
. Schritt 1: Herstellung der Kontaktschicht auf dem Teil der Struktur, welcher dem optischen Isolator entspricht;
. Schritt 2: Entfernen der Kontaktschicht in der sich über der Oberseite der aktiven Zone befindlichen Zone.

8. Herstellungsverfahren nach Anspruch 7, **dadurch gekennzeichnet, dass** der Schritt 2 des Verfahrens durch Ätzen oder lonenätzen erfolgt
